Europäisches Patentamt

European Patent Office

Office européen des brevets

(11) Publication number: **0 432 846 A1**

# EUROPEAN PATENT APPLICATION

(21) Application number: 90203225.9

(51) Int. Cl.5: **G11C 11/412**, G11C 5 00

(22) Date of filing: 07.12.90

(30) Priority: **11.12.89 NL 8903033**

(43) Date of publication of application:
**19.06.91 Bulletin 91/25**

(84) Designated Contracting States:
**DE FR GB IT**

(71) Applicant: N.V. Philips' Gloeilampenfabrieken
Groenewoudseweg 1
NL-5621 BA Eindhoven(NL)

(72) Inventor: List, Frans Jacob
c/o INT. OCTROOIBUREAU B.V., Prof.
Holstlaan 6
NL-5656 AA Eindhoven(NL)

(74) Representative: Strijland, Wilfred et al
INTERNATIONAAL OCTROOIBUREAU B.V.
Prof. Holstlaan 6
NL-5656 AA Eindhoven(NL)

(54) 6-Transistor CMOS memory cell insensitive to alpha-radiation.

(57) The invention relates to an integrated memory comprising 6-transistor full CMOS memory cells. In order to render the cells insensitive to $\alpha$-radiation, a resistance of approximately 70 k$\Omega$ is inserted between the drains of the PMOS-transistor and the NMOS-transistor of each inverter. Furthermore, a double cross-coupling is imparted to the cell: one on the P side and one on the N side. The resistance is realised as a polysilicon track, being the interconnect track between P+ and N+ diffusion regions of the cell.

FIG.1

EP 0 432 846 A1

## "6-TRANSISTOR CMOS MEMORY CELL INSENSITIVE TO α-RADIATION."

The invention relates to a memory which is integrated on a semiconductor substrate and which comprises a matrix of CMOS memory cells which are arranged in rows and columns, each cell comprising two cross-wise retrocoupled inverters, each inverter comprising, connected in series between two supply terminals, a PMOS-transistor, a resistance and an NMOS-transistor.

Such a memory cell for an integrated CMOS static RAM memory is described in IEEE Transactions on Nuclear Sience, Vol. NS 33, No. 6, December 1986, pp. 1730 and further by Richard L. Johnson and Sierra E. Diehl in the article "An improved single event resistive-hardening technique for CMOS static RAMs". As disclosed in the cited publication, the static 6-transistor full CMOS memory cells can be improved as regards loss of information, caused by exposure to α-particles, by inserting resistances in the connection between the output of one inverter and the input of the other inverter and vice versa. In conjunction with the capacitance on the nodes constituting the outputs of the memory cell, an RC circuit is formed which delays the collapse of the potential on the outputs due to collected electrons released by the incidence of an α-particle. As a result, one side of the memory cell remains undisturbed for a longer period of time so that the cell can compensate more of the collected electrons during this time, so that the total charge required to disturb a cell increases. The drawback of the insertion of resistances in the retrocoupling consists in that the writing of information in the memory cell is delayed. Furthermore, the addition of the resistances increases the memory cell surface area. If the collection of charge due to further α-radiation continues beyond the delay time of the RC circuit, the information in the memory cell will ultimately be disturbed after all. The cited publication offers a further solution which is based on the addition of two resistance pairs. In addition to the cross-coupling from one inverter to the other inverter, that is to say a resistance from the input of one inverter to the other inverter and vice versa, a resistance is added between the drain of the PMOS-transistor and the drain of the NMOS-transistor of each inverter. The advantage of this solution consists in that the charge required for disturbing the cell is substantially increased. Drawbacks, however, remain in that the writing behaviour is slower and that a larger substrate surface area is required for realising the resistances.

It is inter alia an object of the invention to provide an integrated memory comprising a matrix of memory cells which are insensitive to α-radiation and which require the same substrate surface area as memory cells for which no steps have been taken against disturbances caused by α-radiation.

To achieve this, an integrated memory in accordance with the invention is characterized in that the gates of the NMOS-transistors are cross-wise connected to the drains of the NMOS-transistors, the gates of the PMOS-transistors being cross-wise connected to the drains of the PMOS-transistors, the drain of at least one MOS-transistor being connected to a bit line via a further MOS-transistor. The steps taken in the integrated memory in accordance with the invention in order to mitigate the described drawbacks include the addition of resistances between the drain contacts of the P-channel and N-channel transistors and the realisation of two direct cross-connections between on the one side each gate of a P-transistor and the drain of another P-transistor, and on the other side between each gate of the N-transistor and the drain of the N-transistor.

A preferred embodiment of an integrated semiconductor memory in accordance with the invention is characterized in that the resistances between the drains of the PMOS-transistors and the NMOS-transistors have a resistance value highe than 50 kΩ.

Embodiments in accordance with the invention will be described in detail hereinafter with reference to the accompanying drawing; therein

Fig. 1 shows a diagram of the 6-transistor full CMOS SRAM cell in accorance with the invention, and

Fig. 2 shows a graph representing the sensitivity to disturbances as a function of the resistance value.

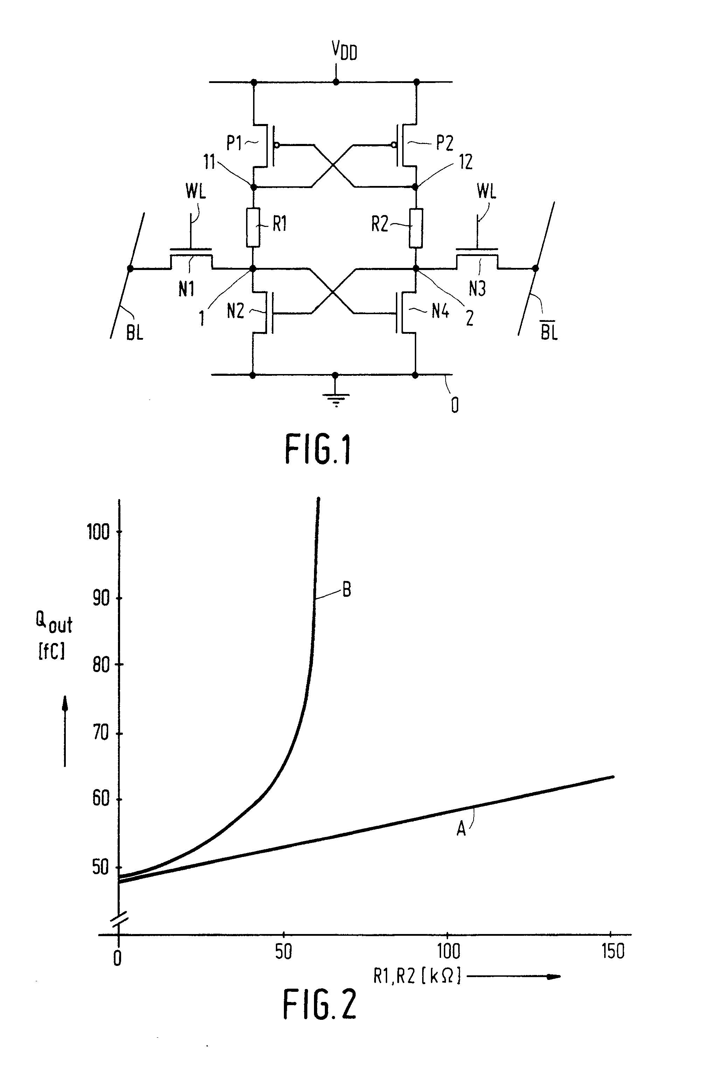

The 6-transistor full CMOS SRAM cell shown in Fig. 1 comprises six transistors, two PMOS-transistors P1 and P2 and four NMOS-transistors N1, N2, N3 and N4. The memory cell furthermore comprises two resistances R1 and R2. The memory cell is connected between two supply leads VDD and O. The outputs 1 and 2 of the CMOS memory cell are connected, via the transistors N1 and N3, to the bit line BL and the non-bit line $\overline{BL}$, respectively. The gates of the transistors N1 and N3 are connected together to a known word line WL (not shown). The gates of the PMOS-transistors P1 and P2 are directly connected to the drains of the respective PMOS-transistors P2 and P1 (nodes 11 and 12, respectively). The gates of the NMOS-transistors N2 and N4 are directly connected to the drain of the NMOS-transistors N4 and N2, respectively. The drains of the PMOS-transistors P1 and P2 are connected to the outputs 1 and 2, respectively, via the resistances R1 and R2, respectively.

Evidently, it is alternatively possible to write and read via a single bit line BL or $\overline{BL}$ or to write via one bit line BL or $\overline{BL}$ and to read via the other bit line $\overline{BL}$ or BL.

It is assumed that the word line WL is low and that the nodes 1 and 11 are high. This means that the PMOS-transistor P1 and the NMOS-transistor N4 are turned on and that the PMOS-transistor P2 and the NMOS-transistor N2 are turned off. When the output node 1 is discharged by collection of electrons, due to the incidence of an $\alpha$-particle, the current which discharges the node 11 is limited by the resistance R1 to (VDD + VD)/R1, where VD is the forward voltage of the NP diode of the N+ drain diffusion which region collects. When the resistance value of the resistance R1 is chosen so that this current can be amply supplied by the conductive transistor P1, the decrease of the potential on the node 11 will only be slight. As a result, the transistor P2 remains turned off so that it cannot charge the node 12 and the output node 2. The node 12, being the drain of the transistor P2, will keep a low potential so that the transistor P1 remains turned on. Consequently, the cell in which charge has collected due to the incidence of the $\alpha$-particle is rendered completely insensitive to the $\alpha$-radiation. The same holds good for the situation where on the node 12 charge is collected in the form of holes generated by the same $\alpha$-radiation.

The graph of Fig. 2 shows a simulation of the quantity of charge, where the information in the memory cell is just not disturbed as a function of the resistance value inserted between the drains of the PMOS- and NMOS-transistors. Two lines are plotted in the graph. Line A represents simulation results for which it has been assumed that the resistance value between the drains of the PMOS-transistor and the NMOS-transistor amounts to zero Ω and resistances RG1 and RG2 are inserted between the gates of the transistors and the drains of the other transistors (see Fig. 6 of the cited publication). Line B represents the simulation values of the critical charge where the information in the memory cell is just not disturbed as a function of the resistance value R1 and R2. The graph shows that an effective protection can be achieved for resistance values higher than 50 kΩ and already lower than 75 kΩ. For resistance values below 50 kΩ, the voltage on the drain of, for example the NMOS-transistor N1 might drop too much, so that information might be lost. For resistance values which are too high, for example higher than 100 kΩ, the writing behaviour of the memory cell will be adversely affected. The foregoing has been simulated for dimensions of a memory cell in an SRAM memory in which the length of the gates of at least the NMOS-transistors is in the sub-micron range.

The simulations have been performed using the following transistors dimensions:

PMOS-transistors:

    gate length:     0.8 $\mu$m
    gate width:     0.8 $\mu$m
NMOS-transistors:

    gate length:     0.7 $\mu$m
    gate width:     1.4 $\mu$m.

For the foregoing simulations it has been assumed that the charge collecting on the output 1 can be described as a current according to: $I_{coll} = Io \cdot exp(-t \ \alpha)$, where Io is the collected current at the instant t = O and $\alpha$ is the time constant of the charge collection. If $Q_{coll}$ is the total charge collected, $O_{coll} = \int I_{coll} \cdot dt$. for the simulation it has been assumed that $\alpha$ is one half ns. VDD is 2 V and that the word lines WL carry 0 V. The nodes 1 and 11 on the one side and the nodes 2 and 12 on the other side are initialized to 2 V and 0 V, respectively, at the start of the simulation. The simulation and the graph reveal that a resistance higher than 50 kΩ and lower than 75 kΩ already suffices to render the cell completely insensitive to $\alpha-$ radiation. The resistances in this cell can be realised in the polysilicon interconnect tracks bridging the distance between the N+ and P+ diffusion regions of the cell, so that the use of resistances in the memory cell actually does not increase the substrate surface area required for a cell. Furthermore, because of the comparatively low values of the resistances, the time constants involved in writing are small. As a result, addition of the resistance hardly influences the writing behaviour of the cell.

## Claims

1. A memory which is integrated on a semiconductor substrate and which comprises a matrix of CMOS memory cells which are arranged in rows and columns, each cell comprising two cross-wise retrocoupled inverters, each inverter comprising, connected in series between two supply terminals, a PMOS-transistor, a resistance and an NMOS-transistor, characterized in that the gates of the NMOS-transistors are cross-wise connected to the drains of the NMOS-transistors, the gates of the PMOS-transistors being cross-wise connected to the drains of the PMOS-transistors, the drain of at least one MOS-transistor being connected to a bit line via a further MOS-transistor.

2. An integrated semiconductor memory as claimed in Claim 1, characterized in that the resistances between the drains of the PMOS-transistors and the NMOS-transistors have a resistance value higher than 50 kΩ.

3. An integrated semiconductor memory as claimed in Claim 1 or 2, characterized in that the dimensions of at least the NMOS-transistors of the memory cell are in the sub-micron range.

4. An integrated semiconductor memory as claimed in Claim 2, characterized in that the resistance value amounts to approximately 75 kΩ.

5. An integrated semiconductor memory as claimed in Claim 1, 2, 3 or 4, characterized in that the resistance is realised in the polysilicon interconnect tracks which connect the drains of the NMOS-transistors in the p regions on the substrate to the drains of the PMOS-transistors in the n regions on the substrate.

$V_{DD}$

P1~          ~P2

11          12

WL          R1    R2          WL

N1          N3

BL          N2    N4          $\overline{BL}$

1          2

0

# FIG.1

$Q_{out}$
[fC]

100

90          B

80

70

60          A

50

0          50          100          150

R1,R2 [kΩ]

# FIG.2

5

European
Patent Office

# EUROPEAN SEARCH
# REPORT

Application Number

**EP 90 20 3225**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PROCEEDINGS OF THE IEEE, vol. 77, no. 3, March 1989, pages 389-407, IEEE, New York, US; R. ZULEEG: "Radiation effects in GaAs FET devices" * Page 398, right-hand column, line 1 - page 399, left-hand column, line 19; figure 17c * | 1,2,4 | G 11 C 11/412 G 11 C 5.00 |
| A | IEEE TRANSACTIONS ON NUCLEAR SCIENCE, vol. NS-32, no. 6, December 1985, pages 4155-4158, IEEE, New York, US; F.-L. HSUEH et al.: "CMOS/SOS high soft-error threshold memory cell" * Page 4155, left-hand column, line 1 - page 4156, left-hand column, line 30; figure 1 * | 1,2,4,5 | |
| A | EP-A-0 317 012 (PHILIPS' GLOEILAMPENFABRIEKEN) * Column 3, line 39 - column 7, line 11; figure 1 * | 1,3 | |

TECHNICAL FIELDS
SEARCHED (Int. Cl.5)

G 11 C 11 412
G 11 C 5.00

The present search report has been drawn up for all claims

| Place of search | Date of completion of search | Examiner |
|---|---|---|
| The Hague | 15 March 91 | DEGRAEVE L.W.G. |